# EUROPÄISCHE PATENTSCHRIFT

(11) **EP 0 685 939 B1**
(45) Veröffentlichungstag und Bekanntmachung des Hinweises auf die Patenterteilung: **25.02.1998**
(21) Anmeldenummer: 95107902.9
(22) Anmeldetag: 24.05.1995
(51) Int. Cl.: H03K 17/00, H05K 3/00

(54) **Elektronischer Lastschalter für Kraftfahrzeuge**
Electronic power switch for motor vehicles
Commutateur électronique de puissance pour des véhicules automobiles

(30) Priorität: 31.05.1994 DE 4419005
(43) Veröffentlichungstag der Anmeldung: 06.12.1995
(73) Patentinhaber: Hella KG Hueck & Co., 59552 Lippstadt (DE)
(72) Erfinder: Lange, Petrik, Dr., D-59557 Lippstadt (DE); Jenss, Volker, D-59555 Lippstadt (DE)

(56) Entgegenhaltungen:
- DE-A- 3 306 120
- DE-A- 4 005 809

## Beschreibung

Die Erfindung betrifft einen elektronischen Lastschalter, bestehend aus einem als Halbleiterschalter ausgeführten elektronischen Leistungsschalter und einer integrierten Ansteuerelektronik.

Für den zunehmenden Ersatz elektromechanischer Lastschalter (Relais) durch elektronische Lastschalter kommen Schaltungsanordnungen, bestehend aus einem elektronischen Halbleiterschalter (Transistor, Thyristor), einer Ansteuerelektronik und optional einer zusätzlichen Beschaltung mit passiven Bauelementen zur Anwendung.

Die Substitution elektromechanischer Lastschalter durch elektronische vollzieht sich dabei vorwiegend in elektronischen Steuergeräten, indem die elektromechanischen Lastschalter durch elektronische Schaltungsteile auf dem Verdrahtungsträger (z. B. der Leiterplatte) ersetzt werden.

Ein elektromechanischer Schalter im Kraftfahrzeug, der ein Steckkontaktteil und eine gekapselte Bauform aufweist, stellt eine eigenständige Baugruppe dar, die über ein entsprechendes Gegensteckkontaktteil an beliebiger Stelle im Kraftfahrzeug elektrisch und mechanisch angebunden werden kann. Die vom Stand der Technik her bekannten elektronischen Leistungsschalter sind zu derartigen "Stand alone"-Relais (Becherrelais) nicht kompatibel.

Verschiedene Bauformen von eigenständigen Halbleiterrelais zeigt das Titelblatt des Prospektes "Halbleiter-Relais, 10/91, Produktübersicht; Das Programm nach Maß für alle Anwendungsbereiche" der Firma Zettler. Eine der dargestellten Bauformen zeigt Halbleiterrelais, die als bedrahtete Bauteile ausgeführt sind und auf eine Leiterplatte gelötet werden können. Bei einer anderen Bauform weist das Gehäuse des Halbleiterrelais Schraubklemmen auf, über welche das Halbleiterrelais mit elektrischen Zuleitungen verbunden werden kann.

Der Prospekt "SSR Solid State Relay; 1993, Customer Reference Brochure" der Firma Motorola zeigt einen elektronischen Lastschalter für Kraftfahrzeuganwendungen, bei dem der Lastschalter innerhalb eines relativ großvolumigen metallischen Gehäuses angeordnet ist, wobei eine flanschartig ausgestaltete Fläche des Gehäuses zur Verbindung mit einem als Wärmesenke fungierenden Metallteil (z. B. dem Motorblock), vorgesehen ist. Die elektrische Kontaktierung dieses elektronischen Lastschalters erfolgt dabei über mehrere Flachsteckverbindungen.

Bei diesen Lastschaltern nach dem Stand der Technik sind die Schaltungsteile innerhalb der Gehäuse auf elektrisch isolierenden Trägern (z. B. Leiterplatte oder Hybridkeramik) aufgebracht. Ein solcher Aufbau eines Lastschalters ist auch in den Unterlagen der Gebrauchsmusteranmeldung G 93 07 386 beschrieben.

Nachteilig hierbei ist, daß die Außenkontaktierung über Kontaktelemente erfolgt, die in der Regel thermisch schlecht oder überhaupt nicht an den elektronischen Leistungsschalter angekoppelt sind. Zur Kühlung werden vorzugsweise Kühlkörper, die elektrisch isolierend und thermisch leitend mit dem Leistungsschalter in Verbindung stehen, eingesetzt.

Die Wärmeabfuhr von dem elektrischen Leistungsschalter erfolgt zunächst über eine isolierende Montageplatte an das Gehäuse und wird von dort über großflächige Kühlflächen an die Umgebung abgegeben oder an eine mit dem Gehäuse verbundene metallische Wärmesenke (z. B. dem Motorblock) verbunden.

Die Offenlegungsschrift DE 40 05 809 A1 beschreibt einen Regler-Baustein für die Ansteuerung von Relais, welcher anstelle eines Relais in die genormte Steckfassung für Relais eingesteckt werden kann. Dieser Reglerbaustein enthält ein serienmäßiges Relais- oder Steckergehäuse, in dem eine integrierte Schaltungsanordnung auf einem zweidimensional strukturierten, nichtisolierenden metallischen Verdrahtungsträger durch Löten oder Verschweißen aufgebracht ist. Der metallische Verdrahtungsträger hat Außenanschlüsse, die als kraftfahrzeugtypisches Steckkontaktteil ausgeformt sind.

Aufgabe der Erfindung ist es, einen elektronischen Lastschalter so auszubilden, daß er möglichst einfach, kostengünstig und kleinbauend herstellbar ist und geeignet ist, herkömmliche elektromechanische Lastschalter unmittelbar, das heißt ohne daß eine Änderung der äußeren Verschaltung des Lastschalters nötig wird, zu ersetzen.

Diese Aufgabe wird erfindungsgemäß durch die im kennzeichnenden Teil des Anspruchs 1 aufgeführten Merkmale gelöst.

Der so aufgebaute erfindungsgemäße elektronische Lastschalter ist in vielerlei Hinsicht vorteilhaft.

So ist der elektronische Lastschalter im Aufbau besonders einfach, da der Verdrahtungsträger den aufgebrachten elektronischen Leistungsschalter sowie die Ansteuerelektronik sowohl mechanisch trägt als auch elektrisch miteinander verbindet.

Vorteilhaft ist auch, daß der metallische Verdrahtungsträger gleichzeitig Außenanschlüsse ausbildet, die als Steckkontaktteil ausgeformt sind und somit die Anschlußkontakte für die Zuleitungen des Lastschalters darstellen.

In diese Anschlußkontakte und in die mit den Anschlußkontakten verbundenen Zuleitungen werden auf besonders vorteilhafte Weise die im elektronischen Leistungsschalter anfallende Wärme abgeführt. Dies ist durch die direkte thermische Ankopplung des Leistungsschalters an den Verdrahtungsträger besonders gut möglich. Dabei ist zudem von Vorteil, daß kein weiteres isolierendes Trägerteil (wie eine Leiterplatte oder eine Hybridkeramik) benötigt wird.

Weitere vorteilhafte Ausgestaltungen und Weiterbildungen gehen aus den Unteransprüchen hervor.

So kann die Strukturierung des metallischen Verdrahtungsträgers auf besonders einfache, schnelle und kostengünstige Weise durch Ausstanzen aus einem Streifen des Verdrahtungsträgermaterials erfolgen. Hierbei ist besonders vorteilhaft, daß mittels Nutzenverarbeitung auch gleich mehrere Verdrahtungsträger gleichzeitig hergestellt bzw. bearbeitet werden können.

Ein weiterer Vorteil liegt darin, daß das Gehäuse des erfindungsgemäßen Lastschalters auf einfache Weise durch Umspritzen des Verdrahtungsträgers und der darauf angeordneten Bauteile mittels Kunststoffmaterials hergestellt werden kann.

Hierdurch wird ein besonders kompakter Aufbau des Lastschalters möglich, der sogar die Kompaktheit vergleichbarer elektromechanischer Lastschalter übertreffen kann.

Hierdurch ist der erfindungsgemäße Lastschalter geeignet, konventionelle elektromechanische Lastschalter zu ersetzen, zwar auf besonders vorteilhafte Weise dann, wenn das Steckkontaktteil des Lastschalters anschlußkompatibel zu einem genormten Steckkontaktteil eines elektromechanischen Lastschalters ist. Hierdurch wird beim Ersatz eines elektromechanischen Lastschalters durch einen elektronischen Lastschalter keine Änderung der Kontaktierung nötig. Insbesondere kann der erfindungsgemäße elektronische Lastschalter in das vorhandene Gegenkontaktteil für den elektromechanischen Lastschalter eingesetzt werden.

Da beim Einsatz des erfindungsgemäßen Lastschalters in bereits existierende Gegenkontaktteile nicht die Wärmeabfuhrmöglichkeit über einen als Montageplatte ausgeführten Kühlkörper gegeben sind, ist es vorteilhaft, daß bei dem erfindungsgemäßen Lastschalter eine zusätzliche Wärmeabfuhrmöglichkeit dadurch geschaffen werden kann, daß zumindest das Teil des metallischen Verdrahtungsträgers, auf welchem der elektronische Leistungsschalter angeordnet ist, Kühlflächen ausbildet, die dann durch Umklappen oberhalb und unterhalb der die Bauteile tragenden Fläche des Verdrahtungsträgers dreidimensionale Kühlflächen ausbildet, die dann die an den Verdrahtungsträger abgegebene Wärme besser an die Kunststoffumspritzung verteilt.

Zudem vergrößern die angeformten Kühlflächen die Wärmekapazität des Verdrahtungsträgers, so daß eine größere Wärmemenge vom Verdrahtungsträger aufgenommen werden kann, was besonders bei starker kurzzeitiger Belastung des elektronischen Leistungsschalters von Vorteil ist.

In diesem Zusammenhang ist es ebenfalls vorteilhaft, wenn der Verdrahtungsträger neben einer guten elektrischen Leitfähigkeit auch eine relativ hohe Wärmekapazität aufweist und beispielsweise aus Kupfer gefertigt ist.

Vorteilhaft ist auch, daß zur Erzielung bestimmter Schaltungseigenschaften auch weitere, diskrete Bauelemente (insbesondere passive Bauteile), ebenfalls auf dem Verdrahtungsträger aufgebracht und mit diesem elektrisch verbunden werden können.

Vorteilhafterweise können auch durch eine spezielle Ausgestaltung des Verdrahtungsträgers bestimmte Schaltungsmaßnahmen getroffen werden. So können beispielsweise Teile des metallischen Verdrahtungsträgers die durch Einbringung eines kleinen Zwischenraumes (z. B. durch Schneiden mittels eines Laserstrahls) elektrisch voneinander isoliert sind, durch den Zwischenraum eine Funkenstrecke ausbilden, die die Ansteuerschaltung oder den Leistungsschalter vor schädlichen Spannungseinflüssen (durch von außen zugeführte elektrostatische Entladungen oder durch die Induktionsspannung einer durch den Leistungsschalter geschalteten induktiven Last) schützt.

Teile des Verdrahtungsträgers können auch als niederohmige Widerstände ausgebildet sein (beispielsweise durch Fertigung und Hinzufügung von Teilen, die aus einem vom übrigen Verdrahtungsträger abweichenden Material oder durch Veränderung der Form oder Dicke eines Teiles beim Stanzvorgang des Verdrahtungsträgers hergestellt sind). Der an solchen Teilen auftretende Spannungsabfall kann von der Ansteuerungselektronik beispielsweise zur Stromüberwachung des Lastkreises und insbesondere zur Erkennung von Kurzschlüssen verwendet werden. Je nach Anwendung können diese als Teile des Verdrahtungsträgers ausgebildeten Widerstände auch eine strombegrenzende Funktion haben.

Als vorteilhafter Spezialfall kann die Ansteuerungselektronik auch einen integrierten Taktgeber enthalten und der Lastschalter somit einen elektronischen Blinkgeber ausbilden. Der Mehraufwand für eine als Blinkgeberansteuerungselektronik ausgebildete Ansteuerungselektronik ist sehr gering.

Ausführungsbeispiele von erfindungsgemäßen Lastschaltern sind in den Zeichnungen dargestellt und sollen im folgenden anhand der Zeichnungen näher erläutert werden.

Es zeigen
- Figur 1: einen elektronischen Lastschalter mit Anschlußsteckerbild nach DIN ISO 7588 im ungehäusten Zustand,
- Figur 2: einen elektronischen Lastschalter entsprechend der Figur 1 im endkonfektionierten Zustand,
- Figur 3: die elektrische Beschaltung des in der Figur 1 dargestellten Lastschalters anhand eines Blockschaltbildes,
- Figur 4: einen elektronischen Lastschalter mit ungenormtem Single-Inline-Anschlußbild.

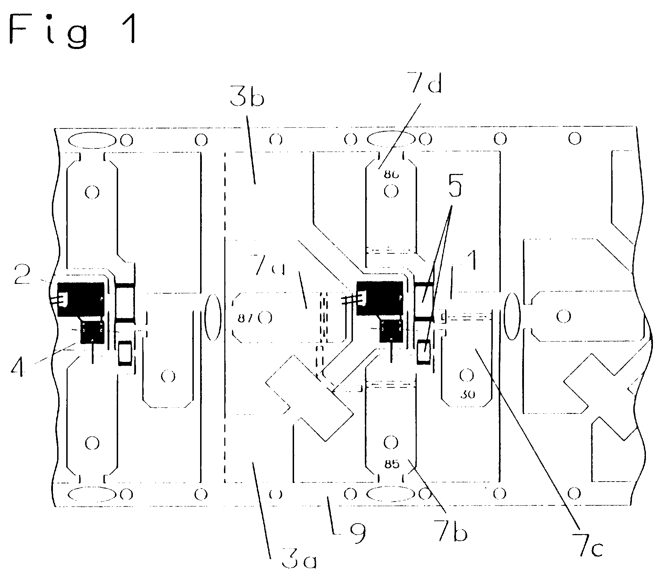

Die in der Figur 1 dargestellte Bauteileanordnung eines erfindungsgemäßen elektronischen Lastschalters besteht aus einem metallischen Verdrahtungsträger (1), der durch mechanische (als Stanzrahmen) oder naßchemische Bearbeitung (durch Ätzen) zweidimensional strukturiert ist. Die Struktur beinhaltet Leiterbahnen für die elektrische Verbindung von Schaltungskomponenten (2, 4, 5), Anschlußfahnen (7a, 7b, 7c, 7c) sowie Kühlbleche (3a, 3b). Die genannten Strukturelemente des metallischen Verdrahtungsträgers (1) werden durch eine äußere Umrandung (9) an ihren Plätzen gehalten. Diese äußere Umrandung (9) dient während der Bearbeitung des Verdrahtungsträgers (1) auch als Transportstreifen (z. B. während des Stanzvorganges).

Die elektrischen und elektronischen Schaltungskomponenten (2, 4, 5) sind auf die Strukturelemente des metallischen Verdrahtungsträgers durch Löten, Leitkleben oder ähnliches aufgebracht und stehen mit diesen in direkter elektrischer und thermischer Verbindung.

Weitere elektrische Verbindungen der Schaltungskomponenten (2, 4, 5) untereinander werden über Bondverbindungen hergestellt.

Die wärmeerzeugenden und auch wärmeempfindlichen aktiven Bauteile, nämlich der elektronische Leistungsschalter (2) (ausgeführt beispielsweise als Leistungs-FET-Transistor) und die Ansteuerungselektronik (4) für den Leistungsschalter (2) sind auf einem möglichst großflächigen Abschnitt des metallischen Verdrahtungsträgers (1) aufgebaut. Dieser Abschnitt bildet zudem zwei Kühlflächen (3a, 3b) aus, wodurch auch das Volumen und damit die Wärmekapazität dieses Abschnittes des metallischen Verdrahtungsträgers (1) weiter erhöht wird. Hierdurch können kurzfristig auftretende große Wärmemengen, wie sie bei Impulsbelastung des Lastschalters am elektronischen Leistungsschalter entstehen gut vom metallischen Verdrahtungsträger (1) aufgenommen werden. Die Kühlflächen (3a, 3b) bewirken aber auch über ihre großen Flächen eine sehr gute thermische Ankopplung des Verdrahtungsträgers (1) an das Gehäuse des Lastschalters, so daß bei Dauerbelastung des Lastschalters entstehende Wärme gut an das Gehäusematerial abgeleitet wird, über dessen Außenfläche die Wärme dann abgestrahlt oder durch Konvektion weggeführt werden kann.

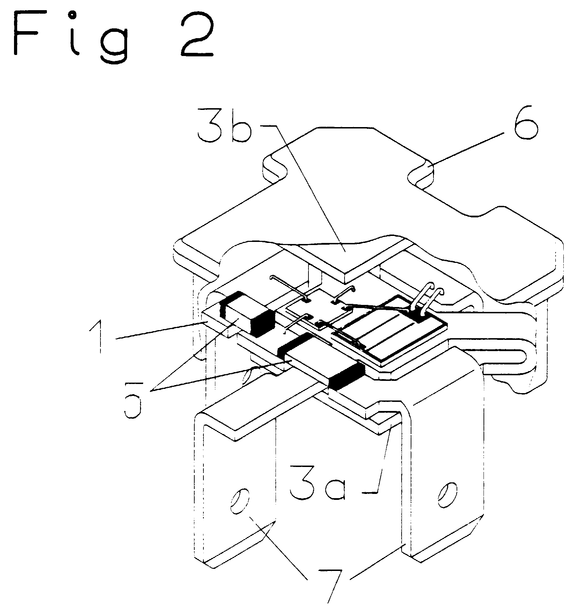

Die Herstellung des gehäusten Lastschalters, wie er in der Figur 2 in einer Schnittdarstellung gezeigt ist, aus der in der Figur 1 gezeigten Anordnung, geschieht folgendermaßen:

Die Kühlflächen (3a, 3b) werden von der Umrandung freigestanzt und im gleichen Arbeitsgang nach unten bzw. oben gebogen, so daß die Kühlflächen (3a, 3b) etwa parallel zu der durch die ursprüngliche Umrandung gegebenen Fläche stehen und dabei ober- und unterhalb der Schaltungskomponenten (2, 4, 5) angeordnet sind. Danach wird eine Kunststoffumspritzung der Schaltungskomponenten (2, 4, 5) und der Kühlflächen (3a, 3b) vorgenommen. Anschließend werden die Anschlußfahnen (7a, 7b, 7c, 7d) von der Umrandung freigestanzt und im Bereich der mehrfach gestrichelten Linien umgebogen.

Eine aufgeschnittene Isometrie des so gefertigten Lastschalters ist in der Figur 2 dargestellt.

Zu erkennen sind die Kühlflächen (3a, 3b) unterhalb und oberhalb der Grundfläche des metallischen Verdrahtungsträgers (1), auf dem (hier nur schematisch dargestellt) die Schaltungskomponenten angeordnet sind. Das Innere des Kunststoffgehäuses (6) muß man sich vollständig mit Kunststoff ausgefüllt vorstellen.

An seiner Unterseite bilden die Anschlußfahnen des größten Lastschalters ein Steckkontaktteil (7), mit dem Anschlußsteckerbild nach DIN ISO 7588 aus, wie es für bestimmte elektromagnetische Lastschalter genormt ist, so daß ein erfindungsgemäßer elektronischer Lastschalter ohne weiteres als Ersatz für einen entsprechenden elektromechanischen Lastschalter verwendet werden kann.

Die beschriebene Ausgestaltung des erfindungsgemäßen elektronischen Lastschalters bewirkt einen äußerst kompakten Aufbau und sehr gut wirksame Maßnahmen gegen thermische Überlastung.

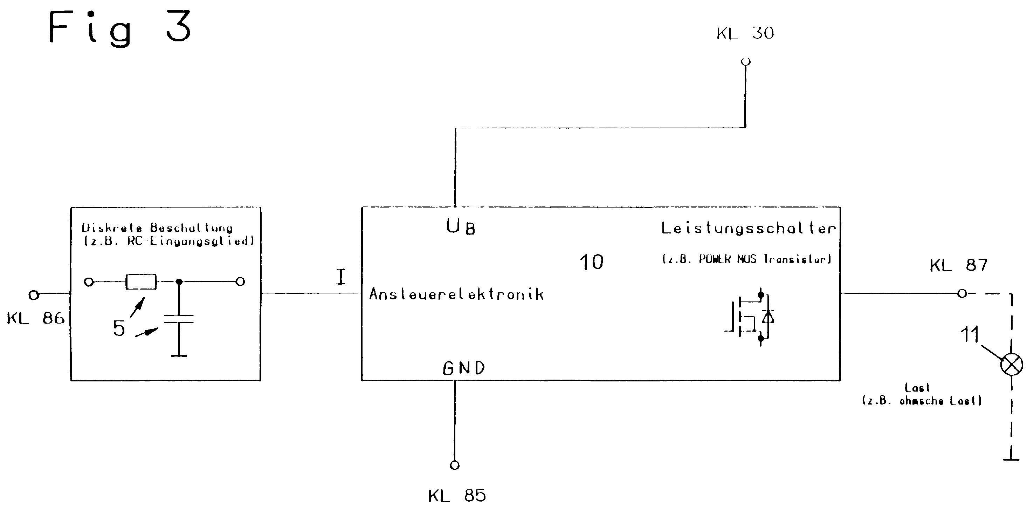

Die an sich bekannte Funktionsweise eines solchen elektronischen Lastschalters soll anhand der Figur 3 kurz umrissen werden. Zum besseren Vergleich mit der Anordnung der Figur 1 weisen die in der Figur 3 dargestellten Anschlüsse eine Numerierung (30, 85, 86, 87) auf, die sich auf den in der Figur 1 dargestellten Anschlußfahnen (7a, 7b, 7c, 7d) wiederfinden und die der Kfz-Steckerbezeichnung gemäß DIN 350 7588 entsprechen.

Die Ansteuerelektronik (4) und der elektronische Leistungsschalter (2) sind hier zu einem Schaltungsblock zusammengefaßt, der zwischen die Bordnetzspannung (UB) und die Fahrzeugmasse (GND) geschaltet ist.

Bei Ansteuerung des Eingangsanschlusses (I) mit einem vorgegebenen Potential schaltet der Schaltungsblock (10) die elektrische Last (11) an die Bordnetzspannung (UB) an.

An die Eingangsleitung (I) sind dabei als passive Bauteile (5) ein Vorwiderstand und ein Kondensator zur Störunterdrückung geschaltet.

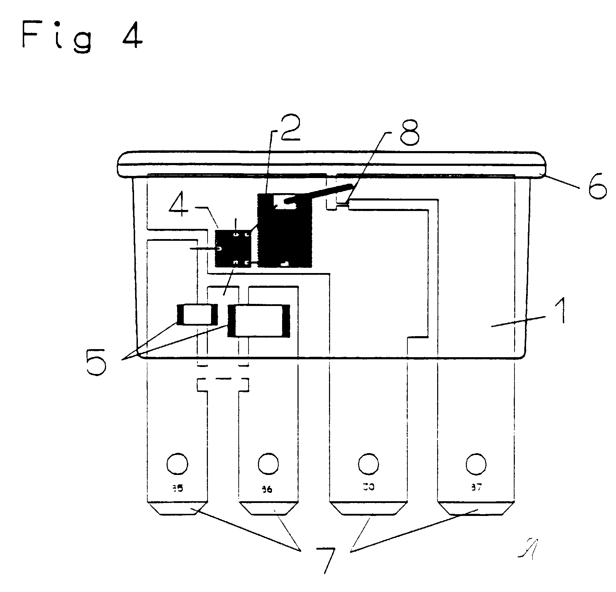

Ein anderes Ausführungsbeispiel eines erfindungsgemäßen elektronischen Lastschalters zeigt die Figur 4.

Auch diese Ausführung besitzt ein kraftfahrzeugtypisches Steckerbild (sogenannte Single-Inline-Anordnung, die von Kraftfahrzeugsicherungen bekannt ist), das allerdings (bisher) nicht für Relaisanwendungen genormt ist.

Der dargestellte Lastschalter zeichnet sich durch vier in einer Reihe zueinander angeordnete Flachstecker aus, wodurch der Lastschalter eine besonders schmale Bauform ausbilden kann.

Im übrigen gleicht die Anordnung vom Verdrahtungsträger (1) und den darauf angeordneten Schaltungskomponenten (2, 4, 5) der in der Figur 1 dargestellten Anordnung. So bildet auch der Verdrahtungsträger (1) des in der Figur 4 dargestellten Lastschalters vorzugsweise dreidimensional ausgeformte Kühlbleche aus, die allerdings in der Figur 4 nicht dargestellt sind.

Als weiteres Merkmal weist die Struktur des Verdrahtungsträgers (1) zwischen den Anschlußfahnen (7b, 7d) eine Funkenstrecke (8) als Überspannungsschutz der elektronischen Schaltungsteile gegen Abschaltimpulse induktiver Lasten und gegen von außen eingebrachte elektrostatische Entladungen auf. Die Elektroden dieser Funkenstrecke bestehen beispielsweise aus einer aufgetrennten Leiterbahnverbindung zwischen den Anschlußfahnen 7b und 7d des Verdrahtungsträgers (1).

Um einen möglichst geringen Abstand der Elektroden zu der Funkenstrecke (8) zu erreichen, kann zum Beispiel eine als dünner Steg ausgebildete Unterbrechung in den Verdrahtungsträger (1) mit einem Laserstrahl eingebracht werden.

Durch Verringerung von Leiterbahnquerschnitten im Verdrahtungsträger (1) können des weiteren Widerstände zur Strombegrenzung im Ansteuer- und Lastkreis realisiert werden, so daß entsprechende diskret ausgeführte Bauteile (5) zumindest teilweise eingespart werden können. Neben der zweidimensionalen Strukturierung können Widerstände auch durch einen Prägevorgang, welcher Leiterbahnquerschnitte verkleinert, realisiert werden.

Der erfindungsgemäße Lastschalter kann vorteilhafterweise auch auf einfache Weise zu einem elektronischen Blinkgeber weiterentwickelt werden, wobei, durch Zufügung einer Taktgeberschaltung zur Ansteuerungselektronik (4), auch dieser die durch die Erfindung erzielten Vorteile, insbesondere die einfache und kostengünstige Möglichkeit der Ersetzung herkömmlicher elektromechanischer Blinkgeber durch elektronische Blinkgeber, aufweist. Eine Lastkontrolle (z. B. für Lampenausfall) kann in der Ansteuerelektronik durch Messung des Laststromes über dem Leistungsschalter realisiert werden.

### Bezugszeichenliste

### Elektronischer Lastschalter für Kraftfahrzeuge

- 1: (metallischer) Verdrahtungsträger
- 2: (elektronischer) Leistungsschalter
- 3a, 3b: Kühlbleche
- 4: Ansteuerelektronik
- 5: elektrische und/oder elektronische (passive) Bauteile
- 6: Kunststoffgehäuse
- 7: Steckkontaktteil
- 7a, 7b, 7c, 7d: Anschlußfahnen
- 8: Funkenstrecke
- 9: Umrandung (Trägerstreifen)
- 10: Schaltungsblock (bestehend aus Leistungsschalter (2) und Ansteuerelektronik (4))
- 11: elektrische Last
- 2, 4, 5: Schaltungskomponenten
- UB: Bordnetzspannung
- GND: Fahrzeugmasse
- 30, 85, 86, 87: Anschlußnumerierung
- I: Eingangsanschluß

## Patentansprüche

1. Elektronischer Lastschalter für Kraftfahrzeuge, bestehend aus einem als Halbleiterschalter ausgeführten elektronischen Leistungsschalter (2) und einer integrierten Ansteuerelektronik (4), dadurch gekennzeichnet, daß der elektronische Leistungsschalter (2) und die integrierte Ansteuerelektronik (4) auf einem zweidimensional in Strukturelemente unterteilten, nichtisolierenden metallischen Vertrahtungsträger (1) aufgebracht und mit diesem elektrisch leitend verbunden sind und daß der metallische Verdrahtungsträger (1) Außenanschlüsse ausbildet, die als kraftfahrzeugtypisches Steckkontaktteil (7) ausgeformt sind, daß das kraftfahrzeugtypische Steckkontaktteil (7) anschlußkompatibel zu genormten Steckkontaktteilen elektromechanischer Lastschalter ist und daß der Verdrahtungsträger (1) dreidimensional ausgeformte Kühlflächen (3a, 3b) ausbildet.

2. Elektronischer Lastschalter nach Anspruch 1, dadurch gekennzeichnet, daß auf den Verdrahtungsträger (1) weitere diskrete elektrische und/oder elektronische Bauteile (5) aufgebracht sind und mit dem Verdrahtungsträger (1) in elektrischer Verbindung stehen.

3. Elektronischer Lastschalter nach Anspruch 1, dadurch gekennzeichnet, daß der metallische Verdrahtungsträger (1) ein Stanzteil ist.

4. Elektronischer Lastschalter nach Anspruch 1, dadurch gekennzeichnet, daß Teilstücke des Verdrahtungsträgers (1) elektrische Widerstände ausbilden.

5. Elektronischer Lastschalter nach Anspruch 1, dadurch gekennzeichnet, daß der Verdrahtungsträger (1) ganz oder zum größten Teil aus Kupfer besteht.

6. Elektronischer Lastschalter nach Anspruch 1, dadurch gekennzeichnet, daß der Verdrahtungsträger (1) und die auf dem Verdrahtungsträger (1) aufgebrachten elektrischen und/oder elektronischen Bauteile (2, 4, 5) mit Kunststoff umspritzt sind.

7. Elektronischer Lastschalter nach Anspruch 1, dadurch gekennzeichnet, daß elektrisch getrennte Leiterabschnitte des metallischen Verdrahtungsträgers (1) eine als Überspannungsschutzvorrichtung wirkende Funkstrecke (8) ausbilden.

8. Elektronischer Lastschalter nach Anspruch 1, dadurch gekennzeichnet, daß in die Ansteuerelektronik (4) ein Taktgeber integriert ist und daß der elektronische Lastschalter einen elektronischen Blinkgeber ausbildet.

## Claims

1. An electronic power circuit breaker for motor vehicles, consisting of an electronic power switch (2) constructed as a semiconductor switch and of an integrated integrated triggering electronics unit (4), characterised in that the electronic power switch (2) and the triggering electronics unit (4) are mounted on a two-dimensional, non-insulating, metallic wiring support (1) which is subdivided into structural elements, and are electrically conductively connected thereto, and that the metallic wiring support (1) forms external connections which are formed as a plug-in contact part (7) typical of motor vehicles, that the plug-in contact part (7) which is typical of motor vehicles is compatible as regards its connections with standard plug-in contact parts of electromechanical power circuit breakers, and that the wiring support (1) forms cooling faces (3a, 3b) which are three-dimensional in shape.

2. An electronic power circuit breaker according to claim 1, characterised in that further discrete electrical and/or electronic components (5) are mounted on the wiring support (1) and are electrically connected to the wiring support (1).

3. An electronic power circuit breaker according to claim 1, characterised in that the metallic wiring support (1) is a stamping.

4. An electronic power circuit breaker according to claim 1, characterised in that portions of the wiring support (1) form electrical resistances.

5. An electronic power circuit breaker according to claim 1, characterised in that the wiring support (1) completely or for the most part consists of copper.

6. An electronic power circuit breaker according to claim 1, characterised in that a plastics material is injection-moulded around the wiring support (1) and the electrical and/or electronic components (2, 4, 5) mounted on the wiring support (1).

7. An electronic power circuit breaker according to claim 1, characterised in that electrically separated conductor sections of the metallic wiring support (1) form a spark gap (8) which acts as an overvoltage protection device.

8. An electronic power circuit breaker according to claim 1, characterised in that a clock unit is integrated in the triggering electronics unit (4) and that the electronic power circuit breaker forms an electronic flasher unit.

## Revendications

1. Interrupteur électronique à coupure en charge pour véhicules à moteur, constitué d'un interrupteur électronique de puissance (2) réalisé sous forme d'interrupteur à semiconducteur et d'une électronique de commande intégrée (4), caractérisé par le fait que l'interrupteur électronique de puissance (2) et l'électronique de commande intégrée (4) sont rapportés sur un support métallique de câblage (1) bidimensionnel, subdivisé en éléments de structure, non isolant, et sont électriquement reliés avec ce support de câblage et que le support métallique de câblage (1) forme des bornes extérieures qui ont la forme de pièces de contact enfichables (7) typiques d'un véhicule à moteur, que la pièce de contact enfichable (7) typique d'un véhicule à moteur est compatible, comme borne, avec les pièces de contact enfichables normalisées des interrupteurs électromécaniques à coupure en charge et que le support de câblage (1) forme des surfaces de refroidissement (3a, 3b) de forme tridimensionnelle.

2. Interrupteur électronique à coupure en charge selon la revendication 1, caractérisé par le fait que d'autres composants discrets, électriques et/ou électroniques (5) sont rapportés sur le support de câblage (1) et sont en liaison électrique avec ce support de câblage (1).

3. Interrupteur électronique à coupure en charge selon la revendication 1, caractérisé par le fait que le support métallique de câblage (1) est une pièce estampée.

4. Interrupteur électronique à coupure en charge selon la revendication 1, caractérisé par le fait que des portions du support de câblage (1) forment des résistances électriques.

5. Interrupteur électronique à coupure en charge selon la revendication 1, caractérisé par le fait que le support de câblage (1) est entièrement ou pour la plus grande partie constitué de cuivre.

6. Interrupteur électronique à coupure en charge selon la revendication 1, caractérisé par le fait que le support de câblage (1) et les composants électriques et/ou électroniques (2,4), rapportés sur le support de câblage (1), sont encastrés dans un plastique injecté.

7. Interrupteur électronique à coupure en charge selon la revendication 1, caractérisé par le fait que des tronçons conducteurs, électriquement séparés, du support métallique de câblage (1) forment un éclateur (8) agissant comme dispositif de protection à l'égard d'une surtension.

8. Interrupteur électronique à coupure en charge selon la revendication 1, caractérisé par le fait que dans l'électronique de commande (4) est intégré un émetteur de signal d'horloge et que l'interrupteur électronique à coupure en charge forme un clignotant électronique.
